# EUROPEAN PATENT SPECIFICATION

(11) **EP 3 503 394 B1**
(45) Date of publication and mention of the grant of the patent: **26.08.2020**
(21) Application number: 17841361.3
(22) Date of filing: 31.07.2017
(51) Int. Cl.: H03K 17/00, H03K 17/687, H03K 17/10, H03K 17/12

(54) **DISCHARGE CIRCUIT FOR CAPACITOR**
ENTLADESCHALTUNG FÜR EINEN KONDENSATOR
CIRCUIT DE DÉCHARGE POUR CONDENSATEUR

(30) Priority: 19.08.2016 JP 2016160971
(43) Date of publication of application: 26.06.2019
(73) Proprietor: Mitsubishi Electric Corporation, Chiyoda-ku Tokyo 100-8310 (JP)
(72) Inventor: KIKUCHI Yuto, Tokyo 100-8310 (JP); OHNO Yuji, Tokyo 100-8310 (JP)
(74) Representative: Witte, Weller & Partner Patentanwälte mbB
(86) International application number: PCT/JP2017/027645
(87) International publication number: WO 2018/034134

(56) References cited:
- EP-A1- 2 284 982
- JP-A- 2011 041 363
- JP-A- 2013 031 259
- JP-A- 2013 038 895
- JP-A- 2014 027 862

## Description

### DISCHARGE CIRCUIT FOR CAPACITOR

### TECHNICAL FIELD

The present invention relates to a discharge circuit for controlling discharge of a capacitor.

### BACKGROUND ART

A conventional discharge circuit for a capacitor is configured by, for example, a series circuit of a discharge resistor and a discharge-controlling switch element being connected in parallel to a capacitor provided between a charging circuit and a ground. The discharge circuit has a mechanism in which the discharge-controlling switch element is turned on in response to a discharge command from a control unit so that electric charges accumulated in the capacitor are discharged through the discharge resistor (e.g., see Japanese Laid-Open Patent Publication No. 2013-143694 (page 4 and FIG. 1)). The document EP 2 284 982 A1 is entitled discharge circuit for smoothing capacitor of DC power supply.

### SUMMARY OF THE INVENTION

### PROBLEMS TO BE SOLVED BY THE INVENTION

In the discharge circuit for the capacitor as in Japanese Laid-Open Patent Publication No. 2013-143694 (page 4 and FIG. 1), control is performed such that the discharge-controlling switch element is turned on to discharge capacitor voltage through the discharge resistor. However, if the discharge-controlling switch element is subjected to an open failure, discharge of the capacitor cannot be controlled. Furthermore, if the discharge-controlling switch element is subjected to a short-circuit failure, a problem arises that the discharge continues and the discharge resistor generates heat.

The present invention has been made to solve the above-described problems, and an object of the present invention is to provide a discharge circuit for a capacitor, capable of performing discharge control even if a discharge-controlling switch element for controlling discharge of the capacitor is subjected to an open failure or a short-circuit failure. The scope of the invention is defined in the appended claim. Any reference to "embodiment(s)", "example(s)" or "aspect(s) of the invention" in this description not falling under the scope of the claim should be interpreted as illustrative example(s) for understanding the invention.

### SOLUTION TO THE PROBLEMS

There is provided a discharge circuit for a capacitor provided between a charging circuit and a ground, the discharge circuit comprising: a control unit for performing control of charge and discharge on the capacitor; a first discharge circuit having a first discharge resistor, a first discharge-controlling switch element, and a first breaking switch element which are connected in series, the first discharge circuit being connected in parallel to the capacitor; and a second discharge circuit having a second discharge resistor, a second dis-charge-controlling switch element, and a second breaking switch element which are connected in series, the second discharge circuit being connected in parallel to the capacitor, the discharge circuit being configured such that the first discharge circuit is used in a normal state, and discharge of the capacitor is controlled through opening and closing of the first discharge-controlling switch element in a state where the first breaking switch element is ON, the discharge circuit further comprising a switching relay for switching connection such that only either of the first discharge circuit and the second discharge circuit is in parallel to the capacitor.

### EFFECT OF THE INVENTION

In the discharge circuit for the capacitor according to the present invention, each of the first discharge circuit and the second discharge circuit is connected in parallel to the capacitor, the first discharge circuit is used in a normal state, and discharge of the capacitor is controlled through opening and closing of the first discharge-controlling switch element in the state where the first breaking switch element is ON. Therefore, even if the first discharge-controlling switch element is subjected to a failure, the second discharge circuit can be used such that discharge of the capacitor is controlled by the second discharge-controlling switch element.

### BRIEF DESCRIPTION OF THE DRAWINGS

[FIG. 1] FIG. 1 is a circuit diagram showing a discharge circuit for a capacitor.
[FIG. 2] FIG. 2 is a circuit diagram showing a discharge circuit for a capacitor.

### DESCRIPTION AND EXAMPLES

### Example 1

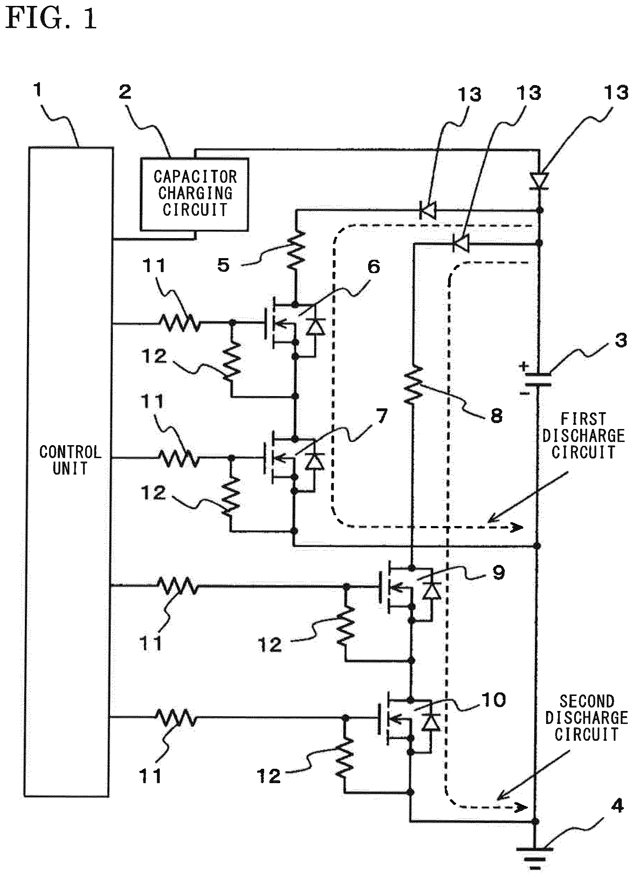

FIG. 1 is a circuit diagram showing the discharge circuit for the capacitor according to example 1. As shown in FIG. 1, in the discharge circuit for the capacitor, one end side of a capacitor 3 is connected to a capacitor charging circuit 2 (corresponding to a charging circuit in CLAIMS) connected to a control unit 1, and the other end side of the capacitor 3 is connected to a ground 4. The control unit 1 is implemented by, for example, a microcomputer including a CPU.

A series circuit of a first discharge resistor 5, a first discharge-controlling switch element 6, and a first breaking switch element 7 is connected in parallel to the capacitor 3. Similarly, a series circuit of a second discharge resistor 8, a second discharge-controlling switch element 9, and a second breaking switch element 10 is connected in parallel to the capacitor 3. Each switch element is implemented by, for example, a MOSFET, and the gate side thereof is connected to the control unit 1 via a damping resistor 11, and a protective resistor 12 is interposed between the gate and the source thereof.

Although not being shown, for example, a breaker operation mechanism is connected at a stage subsequent to the capacitor 3, and capacitor voltage is used as drive power for the breaker operation mechanism. In order to adjust charge voltage of the capacitor 3 or discharge accumulated electric charges in preparation for a next operation, discharge control needs to be performed on the capacitor 3. The discharge circuit for the capacitor according to the present example is used as a discharge circuit for such a case. However, use of the discharge circuit for the capacitor is not limited thereto.

In the configuration in FIG. 1, for the capacitor 3, a discharge path composed of the first discharge resistor 5, the first discharge-controlling switch element 6, and the first breaking switch element 7 is referred to as a first discharge circuit, and a discharge path composed of the second discharge resistor 8, the second discharge-controlling switch element 9, and the second breaking switch element 10 is referred to as a second discharge circuit.

Diodes 13 for preventing reverse flow are respectively interposed at an intermediate portion of a path connected from the capacitor charging circuit 2 to the first and second discharge circuits, and in the first discharge circuit and the second discharge circuit.

The first discharge circuit and the second discharge circuit have the same configuration, and thus either circuit may be defined as the first discharge circuit. That is, by defining one of the circuits as the first discharge circuit, the other circuit is regarded as the second discharge circuit. The present example is characterized in that the discharge circuit is dualized.

Next, discharge operations will be described.

The capacitor 3 is charged by the capacitor charging circuit 2. By commands from the control unit 1, the first breaking switch element 7 is controlled to be turned on, and the first discharge-controlling switch element 6, the second discharge-controlling switch element 9, and the second breaking switch element 10 are controlled to be turned off, in a state where the capacitor 3 is charged but discharge thereof has not been performed.

Next, discharge of the capacitor 3 is performed. Normally, the discharge is performed in the first discharge circuit. Control is performed in which a command is sent from the control unit 1 to the first discharge-controlling switch element 6 so as to turn on the first discharge-controlling switch element 6 for, for example, only 800 ms, so that discharge of the capacitor 3 is performed during a period in which the first discharge-controlling switch element 6 is ON. This is a normal discharge operation.

The period in which the first discharge-controlling switch element 6 is ON, is not limited to 800 ms.

Here, a case where the first discharge-controlling switch element 6 is subjected to an open failure will be described. The state of discharge of the capacitor 3 is constantly monitored by the control unit 1. If an open failure occurs, discharge of the capacitor 3 is not performed. Accordingly, if the control unit 1 detects that discharge of the capacitor 3 has not been performed, the first breaking switch element 7 is turned off, and the second breaking switch element 10 of the second discharge circuit is turned on. Then, the subsequent discharge operation of the capacitor 3 is performed by using the second discharge circuit such that control is performed on the second discharge-controlling switch element 9 by the control unit 1.

In addition, a case where the first discharge-controlling switch element 6 is subjected to a short-circuit failure will be described. If a short-circuit failure occurs, discharge of the capacitor 3 is continued to be performed. Accordingly, if the control unit 1 detects that discharge of the capacitor 3 is continued to be performed, the first breaking switch element 7 is turned off, and the second breaking switch element 10 of the second discharge circuit is turned on. Then, when the subsequent discharge of the capacitor 3 is performed, the second discharge circuit is used such that the discharge operation of the capacitor 3 is controlled by means of the second discharge-controlling switch element 9.

As described above, the discharge operation is normally performed with use of the first discharge circuit, but, even if the first discharge-controlling switch element 6 of the first discharge circuit is subjected to either an open failure or a short-circuit failure, switching to the second discharge circuit is performed, and the discharge operation is performed with use of the second discharge circuit.

If both the first discharge-controlling switch element 6 and the first breaking switch element 7 are subjected to short-circuit failures, both the second breaking switch element 10 and the second discharge-controlling switch element 9 of the second discharge circuit are turned on so that electric charges accumulated in the capacitor 3 are discharged with use of the first discharge resistor 5 and the second discharge resistor 8 so that generated heat is dispersed. That is, if both the first discharge-controlling switch element 6 and the first breaking switch element 7 are subjected to short-circuit failures, the whole voltage charged in the capacitor 3 needs to be discharged, but a long time period is required for the discharge with only the first discharge circuit, and thus, heat generated owing to discharge is dispersed to both discharge resistors, whereby the discharge resistor is prevented from being damaged. Rated powers for the first discharge resistor 5 and the second discharge resistor 8 are determined in consideration of short-time overload.

As described above, the discharge circuit for the capacitor according to example 1 is a discharge circuit for a capacitor provided between the charging circuit and the ground, the discharge circuit including: the control unit for performing control of charge and discharge on the capacitor; the first discharge circuit having the first discharge resistor, the first discharge-controlling switch element, and the first breaking switch element which are connected in series, the first discharge circuit being connected in parallel to the capacitor; and the second discharge circuit having the second discharge resistor, the second discharge-controlling switch element, and the second breaking switch element which are connected in series, the second discharge circuit being connected in parallel to the capacitor, wherein the first discharge circuit is used in a normal state, and discharge of the capacitor is controlled through opening and closing of the first discharge-controlling switch element in a state where the first breaking switch element is ON. Therefore, even if the first discharge-controlling switch element is subjected to a failure, the second discharge circuit can be used such that discharge of the capacitor is controlled by means of the second discharge-controlling switch element.

In addition, if the first discharge-controlling switch element is subjected to a failure, the first breaking switch element is turned off, and the second discharge circuit is used such that discharge of the capacitor is controlled through opening and closing of the second discharge-controlling switch element. Therefore, even if the first discharge-controlling switch element is subjected to an open failure or a short-circuit failure, discharge of the capacitor can be easily controlled through control of the second discharge-controlling switch element.

In addition, if both the first discharge-controlling switch element and the first breaking switch element are subjected to short-circuit failures, both the second discharge-controlling switch element and the second breaking switch element are turned on so that electric charges accumulated in the capacitor are discharged through the first discharge resistor and the second discharge resistor. Therefore, by discharge being performed through both discharge resistors, heat generated owing to the discharge can be dispersed to both discharge resistors, whereby the discharge resistors can be prevented from being damaged.

### Example 2

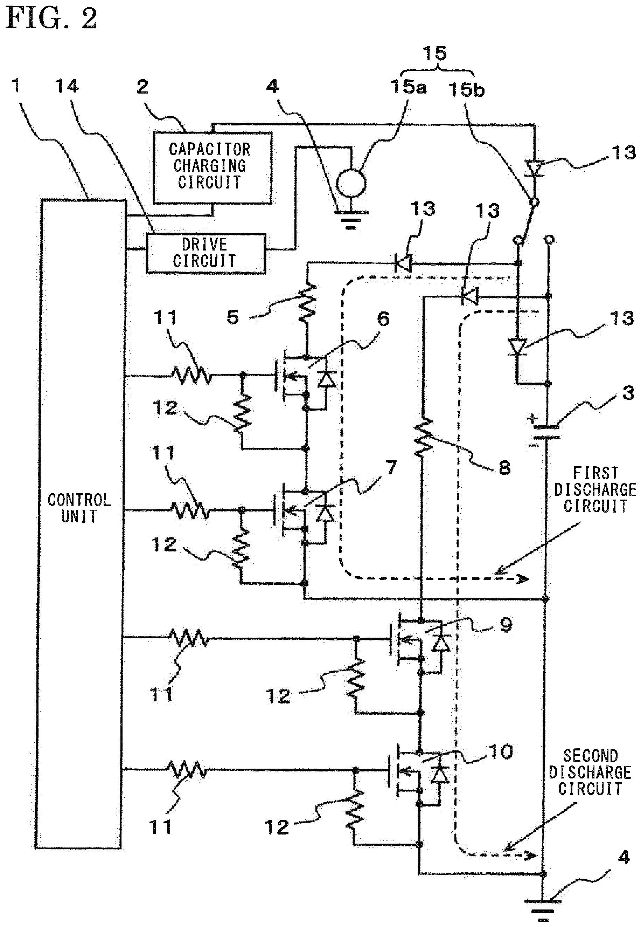

FIG. 2 is a circuit diagram showing a discharge circuit for a capacitor according to example 2. The same components as those in FIG. 1 of example 1 are denoted by the same reference characters, and the detailed description thereof is omitted. Example 1 and example 2 are different from each other in that the first discharge circuit and the second discharge circuit are directly connected in parallel to the capacitor 3 in example 1, whereas a switching relay 15 for switching between the first discharge circuit and the second discharge circuit is added in example 2.

As shown in FIG. 2, the switching relay 15 is composed of a coil portion 15a and a contact portion 15b. The coil portion 15a of the switching relay 15 is provided between the ground 4 and a drive circuit 14 connected to the control unit 1, and the contact portion 15b of the switching relay 15 is provided at a connection point portion where connection is established from the capacitor charging circuit 2 to the first discharge circuit or the second discharge circuit.

The other components are the same as those in FIG. 1 of example 1.

Next, discharge operations of the discharge circuit for the capacitor in FIG. 2 will be described.

By commands from the control unit 1, the first breaking switch element 7 is turned on and the first discharge-controlling switch element 6 is turned off in the first discharge circuit, and both the second discharge-controlling switch element 9 and the second breaking switch element 10 are turned off in the second discharge circuit, in a state where the capacitor 3 is charged but discharge thereof has not been performed. In addition, the switching relay 15 is controlled such that the contact portion 15b is connected to the first discharge circuit side.

Next, in a discharge operation of the capacitor 3, by a command from the control unit 1, the first discharge-controlling switch element 6 is turned on so that discharge of the capacitor 3 is performed only during a period in which the first discharge-controlling switch element 6 is ON.

Here, if the first discharge-controlling switch element 6 is subjected to an open failure, the control unit 1 detects that discharge of the capacitor 3 is not performed, and then, the first breaking switch element 7 is turned off, the second breaking switch element 10 of the second discharge circuit is turned on, and switching of the switching relay 15 is performed such that the contact portion 15b is connected to the second discharge circuit side. Regarding performing of the subsequent discharge of the capacitor 3, the discharge operation of the capacitor 3 is controlled through control of the second discharge-controlling switch element 9.

In addition, if the first discharge-controlling switch element 6 is subjected to a short-circuit failure, the control unit 1 detects that discharge of the capacitor 3 is continued to be performed, and then, the first breaking switch element 7 is turned off, the second breaking switch element 10 is turned on, and the contact portion 15b of the switching relay 15 is connected to the second discharge circuit side. Regarding performing of the subsequent discharge of the capacitor 3, the discharge operation of the capacitor 3 is controlled through control of the second discharge-controlling switch element 9.

Furthermore, if not only the first discharge-controlling switch element 6 of the first discharge circuit but also the first breaking switch element 7 thereof is subjected to a short-circuit failure, the second breaking switch element 10 is turned on, and the contact portion 15b of the switching relay 15 is connected to the second discharge circuit side, so that the discharge operation of the capacitor 3 is controlled by means of the second discharge-controlling switch element 9.

In the aforementioned configuration in example 1, if both switch elements of the first discharge circuit are subjected to failures, discharge control cannot be performed. However, as described above, in the configuration in the present example even if the first discharge-controlling switch element 6 and the first breaking switch element 7 are subjected to short-circuit failures at the same time, switching of the switching relay 15 is performed such that the contact portion 15b is connected to the second discharge circuit, whereby the discharge operation of the capacitor 3 can be controlled by means of the second breaking switch element 10 and the second discharge-controlling switch element 9.

As described above, the discharge circuit for the capacitor according to example 2 includes, in addition to the components in example 1, the switching relay for switching connection such that only either of the first discharge circuit and the second discharge circuit is in parallel to the capacitor. Therefore, even if both the first discharge-controlling switch element and the first breaking switch element are subjected to short-circuit failures, switching to the second discharge circuit is performed so that discharge of the capacitor can be controlled by means of the second discharge-controlling switch element.

### DESCRIPTION OF THE REFERENCE CHARACTERS

- 1: control unit
- 2: capacitor charging circuit
- 3: capacitor
- 4: ground
- 5: first discharge resistor
- 6: first discharge-controlling switch element
- 7: first breaking switch element
- 8: second discharge resistor
- 9: second discharge-controlling switch element
- 10: second breaking switch element
- 11: damping resistor
- 12: protective resistor
- 13: diode
- 14: drive circuit
- 15: switching relay
- 15a: coil portion
- 15b: contact portion

## Claims

1. A discharge circuit for a capacitor provided between a charging circuit and a ground,
the discharge circuit comprising:
a control unit (1) for performing control of charge and discharge on the capacitor (3);
a first discharge circuit having a first discharge resistor (5), a first discharge-controlling switch element (6), and a first breaking switch element (7) which are connected in series, the first discharge circuit being connected in parallel to the capacitor (3); and
a second discharge circuit having a second discharge resistor (8), a second discharge-controlling switch element (9), and a second breaking switch element (10) which are connected in series, the second discharge circuit being connected in parallel to the capacitor (3),
the discharge circuit being configured such that the first discharge circuit is used in a normal state, and discharge of the capacitor is controlled through opening and closing of the first discharge-controlling switch element in a state where the first breaking switch element is ON,
the discharge circuit further comprising
a switching relay (15) for switching connection such that only either of the first discharge circuit and the second discharge circuit is in parallel to the capacitor (3).

## Patentansprüche

1. Entladeschaltung für einen Kondensator, bereitgestellt zwischen einer Ladeschaltung und einer Erdung,
wobei die Entladeschaltung aufweist:
eine Steuerungseinheit (1) zum Durchführen einer Steuerung eines Ladens und Entladens an dem Kondensator (3);
eine erste Entladeschaltung, die einen ersten Entladewiderstand (5), ein erstes Entladesteuerungsschaltelement (6) und ein erstes Unterbrechungsschaltelement (7) aufweist, welche in Reihe verbunden sind, wobei die erste Entladeschaltung parallel zu dem Kondensator (3) verbunden ist; und
eine zweite Entladeschaltung, die einen zweiten Entladewiderstand (8), ein zweites Entladesteuerungsschaltelement (9) und ein zweites Unterbrechungsschaltelement (10) aufweist, die in Reihe verbunden sind, wobei die zweite Entladeschaltung parallel zu dem Kondensator (3) verbunden ist,
wobei die Entladeschaltung derart konfiguriert ist, dass die erste Entladeschaltung in einem Normalzustand verwendet wird und eine Entladung des Kondensators durch Öffnen und Schließen von dem ersten Entladesteuerungs-Schaltelement in einem Zustand gesteuert wird, in dem das erste Unterbrechungsschaltelement AN ist,
wobei die Entladeschaltung des Weiteren aufweist
ein Schaltrelais (15) zum Schalten einer Verbindung, so dass nur entweder die erste Entladeschaltung oder die zweite Entladeschaltung parallel zu dem Kondensator (3) ist.

## Revendications

1. Circuit de décharge pour un condensateur fourni entre un circuit de charge et une terre,
le circuit de décharge comprenant :
une unité de commande (1) pour réaliser une commande de charge et de décharge du condensateur (3) ;
un premier circuit de décharge possédant une première résistance de décharge (5), un premier élément commutateur (6) de commande de décharge, et un premier élément commutateur (7) de rupture qui sont connectés en série, le premier circuit de décharge étant connecté en parallèle au condensateur (3) ; et
un deuxième circuit de décharge possédant une deuxième résistance de décharge (8), un deuxième élément commutateur (9) de commande de décharge, et un deuxième élément commutateur (10) de rupture qui sont connectés en série, le deuxième circuit de décharge étant connecté en parallèle au condensateur (3),
le circuit de décharge étant conçu de telle manière que le premier circuit de décharge est utilisé dans un état normal, et une décharge du condensateur est commandée par l'ouverture et la fermeture du premier élément commutateur de commande de décharge dans un état où le premier élément commutateur de rupture est en MARCHE,
le circuit de décharge comprenant en outre
un relais de commutation (15) pour la commutation de connexion de telle manière que seulement l'un ou l'autre parmi le premier circuit de décharge et le deuxième circuit de décharge est en parallèle au condensateur (3).
